# EUROPEAN PATENT SPECIFICATION

(11) **EP 4 300 539 B1**
(45) Date of publication and mention of the grant of the patent: **27.08.2025**
(21) Application number: 21940563.6
(22) Date of filing: 09.12.2021
(51) Int. Cl.: H01J 37/08, H01J 37/304, H01J 37/305, H01J 37/32

(54) **ION SOURCE DEVICE AND USAGE METHOD THEREFOR, AND VACUUM TREATMENT SYSTEM**
IONENQUELLENVORRICHTUNG UND VERWENDUNGSVERFAHREN DAFÜR SOWIE VAKUUMBEHANDLUNGSSYSTEM
DISPOSITIF DE SOURCE D'IONS ET SON PROCÉDÉ D'UTILISATION, ET SYSTÈME DE TRAITEMENT SOUS VIDE

(30) Priority: 18.05.2021 CN 202110541731
(43) Date of publication of application: 03.01.2024
(73) Proprietor: Jiangsu Leuven Instruments Co. Ltd, Xuzhou, Jiangsu 221300 (CN)
(72) Inventor: HU, Dongdong, Xuzhou, Jiangsu 221300 (CN); LI, Xiaolei, Xuzhou, Jiangsu 221300 (CN); ZHANG, Yaoyao, Xuzhou, Jiangsu 221300 (CN); LIU, Xiaobo, Xuzhou, Jiangsu 221300 (CN); SHI, Xiaoli, Xuzhou, Jiangsu 221300 (CN); ZHANG, Huaidong, Xuzhou, Jiangsu 221300 (CN); CHEN, Lu, Xuzhou, Jiangsu 221300 (CN); XU, Kaidong, Xuzhou, Jiangsu 221300 (CN)
(74) Representative: karo IP
(86) International application number: PCT/CN2021/136739
(87) International publication number: WO 2022/242120

(56) References cited:
- CN-A- 1 215 912
- CN-A- 106 548 918
- CN-A- 109 979 794
- CN-A- 111 385 956
- US-A- 5 391 281
- US-A- 6 036 878
- US-A- 6 036 878
- US-A1- 2004 163 766
- US-A1- 2004 163 766
- US-A1- 2009 189 083
- US-A1- 2018 197 719

## Description

### CROSS-REFERENCE TO RELATED APPLICATION

This application claims priority to Chinese patent application NO. 2021105417317 filed on May 18, 2021 and entitled "ION SOURCE APPARATUS AND USAGE METHOD THEREFOR, AND VACUUM TREATMENT SYSTEM",

### TECHNICAL FIELD

The present invention relates to technology field of ion beam etching, and especially relates to an ion source apparatus and a usage method thereof, and a vacuum treatment system.

### BACKGROUND

In the current processes for manufacturing semiconductor devices, sensors, memory devices and the like, ion beam etching system (IBE) has been adopted in more and more processes. The operating principle of ion beam is that, under low-pressure, the gas is passed into the ion source and the plasma is generated, subsequently the ion beam is pulled out through the ion grid meshes, and the ion in the ion beam is neutralized by the neutralizer, and then the particle beam reaches the substrate surface, so as to achieve the purpose of etching.

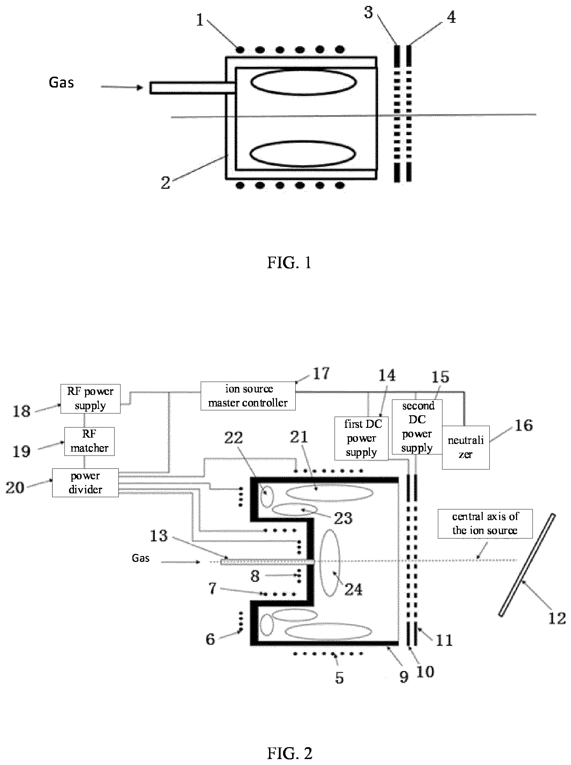

With the decrease on the key size of the devices and the increase on the complexity of the devices, the requirements for the uniformity of the IBE etching process are becoming increasingly high. The process uniformity of the IBE is determined by the performance of its ion source. At present, a helical coil antenna on a discharge cavity is utilized to generate the inductively coupled plasma (ICP) by loading radio frequency (RF) power in the common structure of the ion source (with reference to FIG. 1). The plasma is mainly distributed in the elliptic regions as illustrated in FIG. 1. However, since ICP is mainly diffused due to low-pressure, the distribution of the plasma density of the ion beam pulled by a conventional large-aperture ion source and the ion density flux passing through the ion grid meshes permanently exhibit a convex state, which is the highest at the center of the ion source and decreases radially with increasing distance from the source center, resulting in the non-uniformity of the IBE etching process. Therefore, how to optimize the design on the discharge structure of the ion source so as to generate more uniform plasmas, and further form an ion source with a uniform ion density distribution is the key to solve the uniformity of the IBE etching process.

US 2004/163766 A1 discloses a charged particle source and an operation thereof. US 2018/197719 A1 discloses a method of processing a substrate using an ion beam and apparatus for performing the same. US 6 036 878 A discloses a low density high frequency process for a parallel-plate electrode plasma reactor having an inductive antenna.

### SUMMARY

The invention is defined by the features of the independent claims. Dependent claims refer to preferred embodiments.

Provided in the exemplary embodiments of the present invention is an ion source apparatus and a usage method thereof, and a vacuum treatment system. The changing of the plasma density in the discharge cavity is satisfied by regulating the different power distribution, thereby ensuring the uniformity of the ion beam etching process.

Provided in the embodiments of the present invention is an ion source apparatus, as defined in claim 1. The ion source apparatus comprises a discharge cavity. A cylindrical central axis of the discharge cavity is a central axis of the ion source apparatus, and a wafer is arranged at a position on the central axis of the ion source apparatus where is relative to an open end of the discharge cavity. The ion source apparatus further comprises first discharge coils, second discharge coils, and at least two layers of ion grid meshes. In the first discharge coils, a closed end of the discharge cavity is a U-shape, the first discharge coils are sleeved on a cylindrical outer side wall of the discharge cavity, and a first plasma discharge region for plasma discharge is formed at a position inside the discharge cavity where is proximity to the cylindrical outer side wall. In the second discharge coils, the second discharge coils are arranged at a U-shaped protruding portion of the discharge cavity, and a second plasma discharge region for plasma discharge is formed at a position inside the discharge cavity where is proximity to the U-shaped protruding portion. The at least two layers of ion grid meshes are laid at the open end of the discharge cavity. Both the first discharge coils and the second discharge coils are connected to a power divider.

The ion source apparatus further includes third discharge coils that are coaxially arranged with the first discharge coils on an inner side wall of the U-shaped groove, and a third plasma discharge region used for plasma discharge is formed at a position inside the discharge cavity where is proximity to the inner side wall of the U-shaped groove. The third discharge coil is connected to the power divider.

The ion source apparatus further includes fourth discharge coils that are arranged on an inner bottom wall of the U-shaped groove, and a fourth plasma discharge region for plasma discharge is formed at a position inside the discharge cavity where is proximity to the inner bottom wall of the groove, the fourth discharge coil is connected to the power divider.

In one embodiment, the first discharge coils are sleeved on an outer side of the discharge cavity, and a first radial gap R1 is provided between the first discharge coil and a peripheral wall of the discharge cavity, where the first radial gap R1 ranges from 2 mm to 30 mm; and/or, a second axial gap L1 is provided between the second discharge coils and the protruding portion of the discharge cavity, where the second axial gap L1 ranges from 2 mm to 30 mm; and/or, a third radial gap R2 is provided between the third discharge coils and the groove inner side wall of the discharge cavity, where the third radial gap R2 ranges from 2 mm to 30 mm; and/or, a fourth axial gap L2 is provided between the fourth discharge coils and the groove inner bottom wall of the discharge cavity, where the fourth axial gap L2 ranges from 2 mm to 30 mm.

In one embodiment, the ion source apparatus includes a radio frequency matcher and an ion source master controller; the first discharge coil, the second discharge coil, the third discharge coil and the fourth discharge coil are simultaneously connected to the power divider; the power divider, the radio frequency matcher and the ion source master controller are sequentially connected.

In one embodiment, the ion source master controller is connected to a neutralizer after being in communication with a direct current power supply.

In one embodiment, the ion source apparatus includes an air inlet pipe which vertically passes through the groove inner bottom wall at a central position of the groove inner bottom wall of the closed end.

In one embodiment, a width of the U-shaped protruding portion at the closed end of the discharge cavity is defined as RP, a radius of the inner bottom wall of the U-shaped groove of the discharge cavity is defined as RU, where RU/RP ranges from 1:3 to 3:1.

In one embodiment, the number of layers of the ion grid meshes ranges from 3 to 7.

In one embodiment, a radius of the open end of the discharge cavity is defined as RC, and a size of the RC matches a size of the wafer.

In one embodiment, when the size of the wafer is about 20 cm (8 inches), the size of the R cavity ranges from 50 mm to 250 mm; when the size of the wafer is about 30 cm (12 inches), the size of the R cavity ranges from 100 mm to 300 mm; when the size of the wafer is about 30 cm (12 inches), the size of the radius RC further ranges from 180 mm to 250 mm.

Provided in the embodiments of the present invention is a usage method based on the ion source apparatus, as defined in claim 10. The method comprises as follows. In Step 1, operating parameters for an initial ion source apparatus are set; in Step 2, wafer samples are etched; in Step 3, an uniformity of the etched wafer samples is measured; in Step 4, when a measurement result satisfy preset requirements, a subsequent step is proceeded; when the measurement result does not satisfy the preset requirements, powers from the first discharge coils to the fourth discharge coils are redistributed, the operating parameters for the ion source apparatus are regulated, and then Step 2 is returned for re-processing; and in Step 5, an entire process is terminated and an optimization of a subsequent set of parameters is proceeded.

In one embodiment, in Step 4, powers from the first discharge coils to the fourth discharge coils of the ion source apparatus are redistributed. According to density levels of the first plasma discharge region, the second plasma discharge region, the third plasma discharge region and the fourth plasma discharge region obtained by measurement, the radio frequency powers of the four discharge regions are turned up or down to complete setting the parameters; the first plasma discharge region is formed in the discharge chamber by the first discharge coils, the second plasma discharge region is formed in the discharge chamber by the second discharge coils, the third plasma discharge region is formed in the discharge chamber by the third discharge coils, the fourth plasma discharge region is formed in the discharge chamber by the fourth discharge coils.

In one embodiment, the method for regulating the density level of the plasma discharge regions is specifically as follows. In the case where the plasma densities of the first plasma discharge region and the second plasma discharge region of the wafer samples are high when an etching result of the wafer samples is that a central etching rate is fast and an edge etching rate is slow, the radio frequency powers of the first discharge coils and the second discharge coils can be turned down to decrease the plasma densities of the first plasma discharge region and the second plasma discharge region, or, the radio frequency powers of the third discharge coils and the fourth discharge coils can be turned up to increase the plasma densities of the third plasma discharge region and the fourth plasma discharge region. The current entering the third discharge coils and the fourth discharge coils are inversed with the current entering the first discharge coils and the second discharge coils to decrease a plasma distribution in the third plasma discharge region and the fourth plasma discharge region.

Provided in the embodiments of the present invention is a vacuum treatment system, as defined in claim 13. The system comprises the ion source apparatus according to any one of the above embodiments.

Through the above technical solutions, compared to the prior art, the embodiments in the present invention have the following beneficial effects.
(1) In the embodiments of the present invention, by arranging the discharge cavity as a U-shaped structure, and multiple discharge coils are set to form multiple plasma discharge regions; by combining the discharge coils, different power regulation and distribution are implemented.
(2) In the embodiments of the present invention, through regulating the RF power, the regulations of plasma density in the discharge cavity are satisfied, and the etching results are optimized.

### BRIEF DESCRIPTION OF THE DRAWINGS

The present invention is detailedly elucidated below in conjunction with the accompanying drawings and embodiments.
FIG. 1 illustrates a structural schematic diagram of the prior art provided in the background technology.
FIG. 2 illustrates a structural schematic diagram of an ion source apparatus in an optional embodiment provided in the present invention.
FIG. 3 illustrates a schematic diagram of a definition for dimensions of a discharge cavity in an optional embodiment provided in the present invention.
FIG. 4 illustrates a schematic diagram of plasma discharge regions formed by four sets of discharge coils in an optional embodiment provided in the present invention.
FIG. 5, FIG. 6 and FIG. 7 illustrate three etching results of etching in an optional embodiment provided in the present invention.
FIG. 8 illustrates a schematic diagram of an optimization process for parameters in an optional embodiment provided in the present invention.

In FIG. 1: 1 represents the discharge coils, 2 represents the discharge cavity, 3 and 4 represent the ion grid meshes; in FIG. 2 to FIG. 8, 5 represents the first discharge coils, 6 represents the second discharge coils, 7 represents the third discharge coils, 8 represents the fourth discharge coils, 9 represents the discharge cavity, 10 represents the first ion grid mesh, 11 represents the second ion grid mesh, 12 represents the wafer, 13 represents the air inlet pipe, 14 represents the first direct current power supply, 15 represents the second direct current power supply, 16 represents the neutralizer, 17 represents the ion source master controller, 18 represents the radio frequency power supply, 19 represents the radio frequency matcher, 20 represents the power divider, 21 represents the first plasma discharge region, 22 represents the second plasma discharge region, 23 represents the third plasma discharge region, 24 represents the fourth plasma discharge region.

### DETAILED DESCRIPTION OF THE EMBODIMENTS

The embodiments provided in the present invention are further detailedly elucidated in conjunction with the accompanying drawings. In the descriptions of the present invention, it is to be understood that the terms indicate an orientation or positional relationship such as "left side", "right side", "upper part", "lower part" based on the orientation or positional relationship illustrated in the accompanying drawings, and are intended only to facilitate the descriptions of embodiments of present invention and to simplify the descriptions, rather than indicating or implying that the apparatus or elements referred to must have a specific orientation or be constructed and operated in a specific orientation. The "first", "second" and the like do not indicate the degree of importance of the component, and therefore cannot be construed as a limitation of the embodiments provided in the present invention.

FIG. 1 illustrates a common structure of the ion source mentioned in the background technology at present, where 1 represents the discharge coils, 2 represents the discharge cavity, 3 and 4 represent the ion grid meshes. This kind of structure can easily lead to the nonuniformity of the IBE etching process. In order to solve the problem of non-uniformity of the IBE etching process caused by the un-regulatable plasma density in the background technology, the present invention aims to provide an ion source apparatus that can regulate the density of plasma. The principle is to regulate the density of plasma in the discharge chamber by regulating different power distribution, so as to implement the uniform ion beam etching process.

FIG. 2 illustrates the structural schematic diagram of the entire ion source apparatus. The core of the ion source apparatus is the discharge cavity 9 with a U-shaped closed end, and the cylindrical central axis of the discharge cavity is the central axis of the entire apparatus. Wafer 12 is correspondingly arranged on the central axis, and wafer 12 is arranged relative to the open end of discharge cavity 9. The air inlet pipe 13 passes vertically through the center of the U-shaped groove with a closed end, and the gas enters the discharge cavity 9 through air inlet pipe 13. The U-shaped discharge cavity 9 in the embodiments of present invention may also be a concave-shaped discharge cavity 9 comprising a groove portion and a protruding portion.

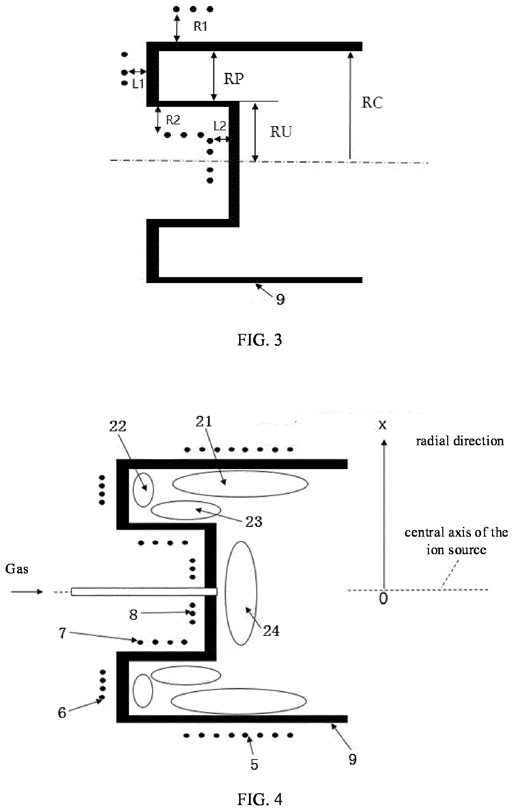

The ion source apparatus further includes four sets of discharge coils, namely, the first discharge coils 5, the second discharge coils 6, the third discharge coils 7 and the fourth discharge coils 8. The arrangement of the four sets of discharge coils are as illustrated in FIG. 4. The first discharge coils 5 are sleeved on a cylindrical outer side wall of the discharge cavity 9, the second discharge coils 6 are arranged at the U-shaped protruding portion of the discharge cavity 9, the third discharge coils 7 is coaxially arranged on the inner side wall of the U-shaped groove with the first discharge coils 5, and the fourth discharge coils 8 are arranged on the inner bottom wall of the U-shaped groove. Four regions for plasma discharge are formed in the discharge chamber 9 by the first discharge coils 5 to the fourth discharge coils 8. It should be noted here that the first discharge coils 5 and the second discharge coils 6 are merely needed to be arranged on the discharge chamber 9, however in order to achieve the optimal regulation effect, the third discharge coils 7 and the fourth discharge coils 8 are also arranged in the present invention, different power regulation distribution are implemented through a single use or a combination use.

Subsequently, the first discharge coils 5, the second discharge coils 6, the third discharge coils 7 and the fourth discharge coils 8 are simultaneously connected with the power divider 20; the power divider 20, the radio frequency matcher 19 and the ion source master controller 17 are sequentially connected. The radio frequency matcher 19 is configured to distribute power to the power divider 20 of the four sets of discharge coils. By combining different discharge regions, different radio frequency powers are loaded on different discharge coils to implement the change of plasma density at different positions along the radial direction from the central axis of discharge cavity 9.

In the present invention, the insulation materials such as quartz and ceramics (such as alumina and zirconia) are preferred for the discharge chamber 9, and the sizes of discharge cavity 9 are set to match wafers 12 of different sizes. In FIG. 3, the radius of the open end of discharge cavity 9 is defined as RC, and the size of RC is matched with the size of wafers 12.

When the size of wafer 12 is about 20 cm (8 inches), the size range of RC can be selected from 50 mm to 250 mm, with a recommended size of 150 mm in the preferred embodiment. When the size of wafer 12 is about 30 cm (12 inches), the size range of RC is selected from 100 mm to 300 mm, with a further recommended size range of 180 mm to 250 mm for optimal etching uniformity.

The ion source apparatus further comprises at least two layers of ion grid meshes which are arranged at the open end of discharge cavity 9, and at least two layers of ion grid meshes are parallel in pairs and arranged vertically with the central axis of discharge cavity 9, and each layer of the ion grid mesh is connected with a DC power supply. The ion grid meshes can be two or more layers, but not more than seven layers, excluding the necessary two layers, the remaining layers are designed to prevent the closest two layers near the open end of discharge cavity 9 from being contaminated, while also regulating the ion density distribution.

As illustrated in FIG. 2, in a preferred embodiment of the present invention, two layers of the ion grid meshes are set, which are the first ion grid mesh 10 and the second ion grid mesh 11 respectively. Each layer of the ion grid meshes is connected to a DC power supply which are defined as the first current power supply 14 and the second DC power supply 15 respectively. The first current power supply 14 and the second DC power supply 15 provide the DC power supply that provides voltage to the ion grid meshes, and then are in communication with the ion source master controller 17 to implement the overall control for the ion source. A neutralizer 16 is further provided in FIG. 2, which is connected to a DC power supply and, is configured to neutralize the charged ion beam pulled out by the ion source after start-up.

As illustrated in FIG. 3, for the four sets of discharge coils, namely, the first discharge coils 5, the second discharge coils 6, the third discharge coils 7 and the fourth discharge coils 8, the placement position limitation relative to the discharge cavity 9 is given. Specifically, the first discharge coils 5 are sleeved on the outer side of the discharge cavity 9, and the first radial gap R1 is provided between the first discharge coils 5 and the peripheral wall of the discharge cavity 9, where the distance of the first radial gap R1 ranges from 2 mm to 30 mm; the second axial gap L1 is provided between the second discharge coils 6 and the protruding portion of the discharge cavity 9, where the distance of the second axial gap L1 ranges from 2 mm to 30 mm; the third radial gap R2 is provided between the third discharge coils 7 and the inner side wall of the groove of the discharge cavity 9, where the distance of the third radial gap R2 ranges from 2 mm to 30 mm; the fourth axial gap L2 is provided between the fourth discharge coils 8 and the inner bottom wall of the groove of the discharge cavity 9, where the distance of the fourth axial gap L2 range from 2 mm to 30 mm. The distance of the first radial gap R1, the second axial gap L1, the third radial gap R2 and the fourth axial gap L2 are limited to a certain range to avoid a significant attenuation of plasma density.

At the same time, the width of the U-shaped protruding portion of the discharge cavity 9 is defined as RP, the radius of the inner bottom wall of the U-shaped groove of the discharge cavity 9 is defined as RU, and the RU/RP ranges from 1:3 to 3:1. Similarly, the proportional range for the sizes of RP and RU is set to give full play to the regulation effect of the discharge coils.

In the preferred embodiment of the present invention, during the operation, the power for generating the plasma in the discharge chamber 9 is provided by the radio frequency power supply 18 with a power range of 0 to 3 kW, and there are commonly three distribution methods when the power divider 20 is distributing.

The first distribution method is that two arbitrary sets of the discharge coils operate together for discharge, such as the first discharge coils 5 and the second discharge coils 6 can be selected to operate in combination, the first discharge coils 5 and the third discharge coils 7 can be selected to operate in combination, that is, the sub-combinations formed by two arbitrary combinations in the four sets of discharge coils satisfy the requirements. After selecting a set of discharge coils to operate in combination, the power distribution ratio is Ratio=1:5000 to 500:1.

The second distribution method is to select merely one discharge coils to operate alone, that is, the power is not distributed, and all are loaded on a separate discharge coils, so the discharge coils merely need to select one from the first discharge coils 5 to the fourth discharge coils 8 to form a single coil subset.

The third distribution method is to select three arbitrary discharge coils to participate in the operation. At this time, firstly one discharge coils is selected from the set (the first discharge coils 5, the second discharge coils 6, the third discharge coils 7 and the fourth discharge coils 8) and recorded as the coil priority. Then, the subset containing two discharge coils which are randomly selected from the remaining three discharge coils is selected and recorded as the coil subset. The power distribution is performed preferentially Ratio1=coil priority: coil subset=1:1000 to 100:1; then the power distribution ratio between the two discharge coils in the coil subset is determined by Ratio2=1:5000 to 500:1.

The fourth distribution method is that the four sets of discharge coils all participate in the operation, and at this time, the power distribution ratio is more complex, which will elaborate specifically herein. There are two preferred implementations, the first one is to split the set of discharge coils (the first discharge coils 5, the second discharge coils 6, the third discharge coils 7, the fourth discharge coils 8) into two subsets. Each subset contains two discharge coils, the discharge coils of each subset are short-circuited into a single discharge coil, which are recorded as coil subset I and coil subset II. The power distribution ratio of the two subsets of discharge coils is ratio subset=coil subset 1: coil subset 2= 1:5000 to 500:1. The second one is also to split the discharge coils into two subsets, each subset contains two discharge coils, and the power distribution of the two subsets is determined by the ratio subset=1:1000 to 100:1. The power distribution of the two discharge coils in each subset is then determined by the ratio sub-coils=1:5000 to 500:1. When the power distribution is relatively complicated, at least one set of RF power supply 18 is selected to be configured for the ion source apparatus, or an independent RF power supply 18 and RF divider is configured for each discharge coils, and the same function is implemented by setting the corresponding RF power for different RF power supplies 18 directly by referring to the power distribution ratio.

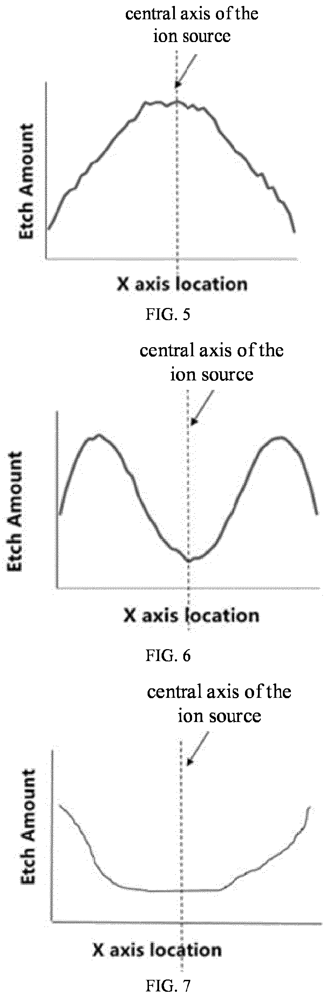

When the ion source apparatus is configured to operate in the entire IBE system, the final etching process results commonly have the following three situations. The uniformity profile results of the typical etching results of the three IBE systems are as illustrated in FIG. 5, FIG. 6 and FIG. 7. The etching result I as illustrated in FIG. 5 has a rapid etching rate in the center and a slow etching rate on the edge, which represents a high plasma density in the center (corresponding to the first plasma discharge region 21 and/or the second plasma discharge region 22 in FIG. 4) and a low plasma density on the edge (corresponding to the third plasma discharge region and/or the fourth plasma discharge region in FIG. 4). The etching result II as illustrated in FIG. 6 is an M-shaped result with a slow etching rate in the center and edge position and a rapid etching rate at the middle position, which represents a low plasma density in the center and edge position (corresponding to the first plasma discharge region and/or the fourth plasma discharge region in FIG. 4) and a high plasma density at the middle position (corresponding to the second plasma discharge region and/or the third plasma discharge region in FIG. 4). The etching result III as illustrated in FIG. 7 has a slow etching rate in the center and a rapid etching rate on the edge, which represents a low plasma density in the center (corresponding to the first plasma discharge region 21 and/or the second plasma discharge region 22 in FIG. 4) and a high plasma density on the edge (corresponding to the third plasma discharge region and/or the fourth plasma discharge region in FIG. 4). According to the etching results, the operating parameters of the power distribution plasma source are optimized to obtain the optimal etching uniformity.

Subsequently, by taking the etching result I as illustrated in FIG. 5 as an example, the plasma density in the first plasma discharge region 21 and/or the second plasma discharge region 22 need to be reduced to optimize the etching result, that is, the RF power connected to the first discharge coils 5 and/or the second discharge coils 6 need to be reduced; or, the plasma density of the third plasma discharge region 23 and/or the fourth plasma discharge region 24 are increased, while inverting the current entering the third discharge coils 7 and the fourth discharge coils 8 with the current entering the first discharge coils 5 and the second discharge coils 6, which can offset the magnetic flux in the middle region, reduce the plasma distribution in the middle region, and minimize the influence of the first discharge coils 5 and the second discharge coils 6 on the etching depth in the middle region. As can be seen from FIG. 4, the middle region herein is the third plasma discharge region 23 and the fourth plasma discharge region 24, and then the etching uniformity can be regulated to a good development direction. In a similar way, when the etching result is the situation II as illustrated in FIG. 6 or the situation III as illustrated in FIG. 7, the plasma density in the corresponding region needs to be regulated, the magnitude of RF power loaded on different discharge coils, the current reversal of different discharge coils, or the combination of short-circuiting different discharge coils, and the like, actually need to be correspondingly regulated.

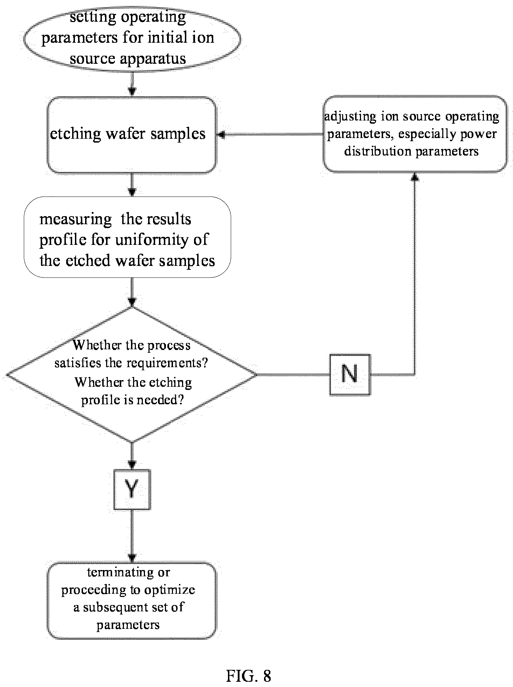

The specific process of optimizing the operating parameters for the ion source apparatus needs to be combined with the process of etching technology to optimize and regulate within the entire parameter range. The specific parameter optimization process is as illustrated in FIG. 8. Firstly, the initial ion source operating parameters are set, and then the etching process results are measured by etching wafer samples to observe the shape of the results profile. By different profiles, it can be determined whether the density of one of the four plasma discharge regions needs to be regulated high or low, or whether other operating parameters of the ion source apparatus need to be regulated, such as the voltage or current loaded on the ion grid meshes. Through this process, the uniformity of the etching process results under most conditions can satisfy the requirements, such as a high power etching, a low power etching, and a medium energy etching.

Through the exposition in the above implementations, it can be determined that the optimized discharge structure of the ion source apparatus involved in the present invention can produce a more uniform plasma, and further form an ion source with a uniform distribution of particle density, and eventually implement the uniformity of the IBE etching process.

Eventually, the present invention further provides a vacuum treatment system including the ion source apparatus, that is, the ion source apparatus can be installed in the vacuum treatment system.

It can be understood by those skilled in the art that, unless otherwise defined, all terms used herein (both technical and scientific terms) have the same meaning as would be generally understood by those skilled in the art to which the present invention belongs. It should also be understood that terms such as those defined in a generic dictionary should be understood to have a meaning consistent with the meaning in the context of the prior art and, unless defined as herein, will not be interpreted with idealized or overly formal meanings.

The meaning of "and/or" as used in the present invention refers to the situations where they exist separately or simultaneously.

The meaning of "connection" as used in the present invention refers to either a direct connection between components or an indirect connection between components through other components. For the sake of simplicity, unless otherwise defined, when a component is described as "connected" to another component in the present invention, it means that the component is electrically connected to the other component. The technical features of the above embodiments may be combined arbitrarily. For the sake of conciseness of description, all possible combinations of the technical features in the above embodiments are not described. However, as long as there is no contradiction in the combination of these technical features, they should be considered as the scope of this description.

## Claims

1. An ion source apparatus, comprising a discharge cavity (9), wherein a cylindrical central axis of the discharge cavity (9) is a central axis of the ion source apparatus, a wafer (12) is arranged at a position on the central axis of the ion source apparatus where is relative to an open end of the discharge cavity (9); the ion source apparatus further comprising: a power divider, first discharge coils (5), wherein a closed end of the discharge cavity (9) is a U-shape, the first discharge coils (5) are sleeved on a cylindrical outer side wall of the discharge cavity (9), and the first discharge coils (5) are configured to form a first plasma discharge region (21) for plasma discharge at a position inside the discharge cavity (9) proximate to the cylindrical outer side wall;
second discharge coils (6), arranged at a U-shaped protruding portion of the discharge cavity (9), wherein the second discharge coils (6) are configured to form a second plasma discharge region (22) for plasma discharge at a position inside the discharge cavity (9) proximate to the U-shaped protruding portion; and
at least two layers of ion grid meshes (10, 11), laid at the open end of the discharge cavity (9); wherein both the first discharge coils (5) and the second discharge coils (6) are connected to the power divider,
wherein the ion source apparatus further includes third discharge coils (7) that are coaxially arranged with the first discharge coils (5) on an inner side wall of a U-shaped groove, and that are configured to form a third plasma discharge region (23) for plasma discharge at a position inside the discharge cavity (9) proximate to the inner side wall of the U-shaped groove;
wherein the third discharge coils (7) are connected to the power divider,
wherein the ion source apparatus further includes fourth discharge coils (8) that are arranged on an inner bottom wall of the U-shaped groove, and that are configured to form a fourth plasma discharge region (24) for plasma discharge at a position inside the discharge cavity (9) proximate to the inner bottom wall of the U-shaped groove,
wherein, the fourth discharge coils (8) are connected to the power divider.

2. The ion source apparatus according to claim 1, wherein the first discharge coils (5) are sleeved on an outer side of the discharge cavity (9), and a first radial gap R1 is provided between the first discharge coils (5) and a peripheral wall of the discharge cavity (9), where the first radial gap R1 ranges from 2 mm to 30 mm; and/or
a second axial gap L1 is provided between the second discharge coils (6) and the U-shaped protruding portion of the discharge cavity (9), where the second axial gap L1 ranges from 2 mm to 30 mm; and/or
a third radial gap R2 is provided between the third discharge coils (7) and the inner side wall of the U-shaped groove of the discharge cavity (9), where the third radial gap R2 ranges from 2 mm to 30 mm; and/or
a fourth axial gap L2 is provided between the fourth discharge coils (8) and the inner bottom wall of the U-shaped groove of the discharge cavity (9), where the fourth axial gap L2 ranges from 2 mm to 30 mm.

3. The ion source apparatus according to claim 1, wherein the ion source apparatus includes a radio frequency matcher and an ion source master controller (17); the first discharge coils (5), the second discharge coils (6), the third discharge coils (7) and the fourth discharge coils (8) are simultaneously connected to the power divider; the power divider, the radio frequency matcher and the ion source master controller (17) are sequentially connected.

4. The ion source apparatus according to claim 3, further comprising a neutralizer (16) and a direct current power supply, wherein the ion source master controller (17) is sequentially connected to the direct current power supply and to the neutralizer (16).

5. The ion source apparatus according to claim 1, wherein the ion source apparatus includes an air inlet pipe (13) arranged to vertically pass through the U-shaped groove inner bottom wall at a central position of the U-shaped groove inner bottom wall of the closed end.

6. The ion source apparatus according to claim 1, wherein a width of the U-shaped protruding portion of the discharge cavity (9) is RP, a radius of the inner bottom wall of the U-shaped groove of the discharge cavity (9) is RU, where RU/RP ranges from 1:3 to 3:1.

7. The ion source apparatus according to claim 1, wherein a number of layers of the ion grid meshes (10, 11) ranges from 3 to 7.

8. The ion source apparatus according to claim 1, wherein a radius of the open end of the discharge cavity (9) is RC, and a size of the radius RC matches a size of the wafer (12);
when the size of the wafer (12) is about 20 cm, the size of the R cavity ranges from 50 mm to 250 mm; or
when the size of the wafer (12) is about 30 cm, the size of the R cavity ranges from 100 mm to 300 mm.

9. The ion source apparatus according to claim 8, wherein when the size of the wafer (12) is about 30 cm, the size of the radius RC ranges from 180 mm to 250 mm.

10. A usage method for the ion source apparatus according to any one of claims 1 to 9, comprising:
Step 1, setting operating parameters for an initial ion source apparatus;
Step 2, etching wafer (12) samples;
Step 3, measuring an uniformity of the etched wafer (12) samples;
Step 4, proceeding to a subsequent step when a measurement result satisfies preset requirements; redistributing, when the measurement result does not satisfy the preset requirements, powers from the first discharge coils (5) to the fourth discharge coils (8), regulating the operating parameters for the ion source apparatus, and then returning to Step 2 for re-processing; and
Step 5, terminating an entire process and proceeding to optimize a subsequent set of parameters.

11. The method according to claim 10, wherein in Step 4, the step of redistributing powers from the first discharge coils (5) to the fourth discharge coils (8) in the ion source apparatus includes steps of:
turning, according to density levels of the first plasma discharge region (21), the second plasma discharge region (22), the third plasma discharge region (23) and the fourth plasma discharge region (24) obtained by the measurement, the radio frequency powers of the four discharge regions up or down to complete setting the parameters; wherein the first plasma discharge region (21) is formed in the discharge chamber by the first discharge coils (5), the second plasma discharge region (22) is formed in the discharge chamber by the second discharge coils (6), the third plasma discharge region (23) is formed in the discharge chamber by the third discharge coils (7), the fourth plasma discharge region (24) is formed in the discharge chamber by the fourth discharge coils (8).

12. The method according to claim 11, wherein the step of turning, according to density levels of the first plasma discharge region (21), the second plasma discharge region (22), the third plasma discharge region (23) and the fourth plasma discharge region (24) obtained by the measurement, the radio frequency powers of the four discharge regions up or down, includes steps of:
turning down the radio frequency powers of the first discharge coils (5) and the second discharge coils (6) to decrease the plasma densities of the first plasma discharge region (21) and the second plasma discharge region (22), or, turning up the radio frequency powers of the third discharge coils (7) and the fourth discharge coils (8) to increase the plasma densities of the third plasma discharge region (23) and the fourth plasma discharge region (24), in a case where the plasma densities of the first plasma discharge region (21) and the second plasma discharge region (22) of the wafer (12) samples are high when an etching result of the wafer (12) samples is that a central etching rate is fast and an edge etching rate is slow;
inversing the current entering the third discharge coils (7) and the fourth discharge coils (8) with the current entering the first discharge coils (5) and the second discharge coils (6) to decrease a plasma distribution in the third plasma discharge region (23) and the fourth plasma discharge region (24).

13. A vacuum treatment system, comprising the ion source apparatus according to any one of claims 1 to 9

## Patentansprüche

1. Ionenquellenvorrichtung, die einen Entladungshohlraum (9) umfasst, wobei eine zylindrische Mittelachse des Entladungshohlraums (9) eine Mittelachse der Ionenquellenvorrichtung ist, wobei ein Wafer (12) an einer Position auf der Mittelachse der Ionenquellenvorrichtung angeordnet ist, relativ zu einem offenen Ende des Entladungshohlraums (9); wobei die Ionenquellenvorrichtung ferner umfasst: einen Leistungsteiler, erste Entladungsspulen (5), wobei ein geschlossenes Ende des Entladungshohlraums (9) U-förmig ist, die ersten Entladungsspulen (5) auf einer zylindrischen Außenseitenwand des Entladungshohlraums (9) ummantelnd vorgesehen sind und die ersten Entladungsspulen (5) so konfiguriert sind, dass sie einen ersten Plasmaentladungsbereich (21) zur Plasmaentladung an einer Position innerhalb des Entladungshohlraums (9) nahe der zylindrischen Außenseitenwand bilden;
zweite Entladungsspulen (6), die an einem U-förmig vorstehenden Abschnitt des Entladungshohlraums (9) angeordnet sind, wobei die zweiten Entladungsspulen (6) so konfiguriert sind, dass sie einen zweiten Plasmaentladungsbereich (22) zur Plasmaentladung an einer Position innerhalb des Entladungshohlraums (9) nahe des U-förmig vorstehenden Abschnitts bilden; und
mindestens zwei Schichten von Ionengittermaschen (10, 11), die am offenen Ende des Entladungshohlraums (9) angeordnet sind;
wobei sowohl die ersten Entladungsspulen (5) als auch die zweiten Entladungsspulen (6) mit dem Leistungsteiler verbunden sind,
wobei die Ionenquellenvorrichtung ferner dritte Entladungsspulen (7) einschließt, die koaxial mit den ersten Entladungsspulen (5) an einer inneren Seitenwand einer U-förmigen Nut angeordnet sind und die so konfiguriert sind, dass sie einen dritten Plasmaentladungsbereich (23) zur Plasmaentladung an einer Position innerhalb des Entladungshohlraums (9) nahe der inneren Seitenwand der U-förmigen Nut bilden;
wobei die dritten Entladungsspulen (7) mit dem Leistungsteiler verbunden sind,
wobei die Ionenquellenvorrichtung ferner vierte Entladungsspulen (8) einschließt, die an einer inneren unteren Wand der U-förmigen Nut angeordnet und so konfiguriert sind, dass sie einen vierten Plasmaentladungsbereich (24) zur Plasmaentladung an einer Position innerhalb des Entladungshohlraums (9) nahe der inneren unteren Wand der U-förmigen Nut bilden,
wobei die vierten Entladungsspulen (8) mit dem Leistungsteiler verbunden sind.

2. Ionenquellenvorrichtung nach Anspruch 1, wobei die ersten Entladungsspulen (5) auf einer Außenseite des Entladungshohlraums (9) ummantelnd vorgesehen sind und ein erster radialer Spalt R1 zwischen den ersten Entladungsspulen (5) und einer Umfangswand des Entladungshohlraums (9) vorgesehen ist, wobei der erste radiale Spalt R1 im Bereich von 2 mm bis 30 mm liegt; und/oder
ein zweiter axialer Spalt L1 zwischen den zweiten Entladungsspulen (6) und dem U-förmig vorstehenden Abschnitt des Entladungshohlraums (9) vorgesehen ist, wobei der zweite axiale Spalt L1 im Bereich von 2 mm bis 30 mm liegt; und/oder
ein dritter radialer Spalt R2 zwischen den dritten Entladungsspulen (7) und der inneren Seitenwand der U-förmigen Nut des Entladungshohlraums (9) vorgesehen ist, wobei der dritte radiale Spalt R2 im Bereich von 2 mm bis 30 mm liegt; und/oder
ein vierter axialer Spalt L2 zwischen den vierten Entladungsspulen (8) und der inneren unteren Wand der U-förmigen Nut des Entladungshohlraums (9) vorgesehen ist, wobei der vierte axiale Spalt L2 im Bereich von 2 mm bis 30 mm liegt.

3. Ionenquellenvorrichtung nach Anspruch 1, wobei die Ionenquellenvorrichtung einen Hochfrequenzanpasser und eine Ionenquellen-Hauptsteuerung (17) einschließt; die ersten Entladungsspulen (5), die zweiten Entladungsspulen (6), die dritten Entladungsspulen (7) und die vierten Entladungsspulen (8) gleichzeitig mit dem Leistungsteiler verbunden sind; der Leistungsteiler, der Hochfrequenzanpasser und die Ionenquellen-Hauptsteuerung (17) nacheinander verbunden sind.

4. Ionenquellenvorrichtung nach Anspruch 3, die ferner einen Neutralisator (16) und eine Gleichstromversorgung umfasst, wobei die Ionenquellen-Hauptsteuerung (17) nacheinander mit der Gleichstromversorgung und mit dem Neutralisator (16) verbunden ist.

5. Ionenquellenvorrichtung nach Anspruch 1, wobei die Ionenquellenvorrichtung ein Lufteinlassrohr (13) einschließt, das so angeordnet ist, dass es vertikal durch die innere untere Wand der U-förmigen Nut an einer zentralen Position der inneren unteren Wand der U-förmigen Nut des geschlossenen Endes verläuft.

6. Ionenquellenvorrichtung nach Anspruch 1, wobei eine Breite des U-förmigen vorstehenden Abschnitts des Entladungshohlraums (9) RP ist, ein Radius der inneren unteren Wand der U-förmigen Nut des Entladungshohlraums (9) RU ist, wobei RU/RP im Bereich von 1:3 bis 3:1 liegt.

7. Ionenquellenvorrichtung nach Anspruch 1, wobei eine Anzahl der Schichten der Ionengittermaschen (10, 11) im Bereich von 3 bis 7 liegt.

8. Ionenquellenvorrichtung nach Anspruch 1, wobei ein Radius des offenen Endes des Entladungshohlraums (9) RC ist und eine Größe des Radius RC einer Größe des Wafers (12) entspricht;
wenn die Größe des Wafers (12) etwa 20 cm beträgt, liegt die Größe des Hohlraums R im Bereich von 50 mm bis 250 mm; oder
wenn die Größe des Wafers (12) etwa 30 cm beträgt, liegt die Größe des Hohlraums R im Bereich von 100 mm bis 300 mm.

9. Ionenquellenvorrichtung nach Anspruch 8, wobei, wenn die Größe des Wafers (12) etwa 30 cm beträgt, die Größe des Radius RC im Bereich von 180 mm bis 250 mm liegt.

10. Verwendungsverfahren für die Ionenquellenvorrichtung nach einem der Ansprüche 1 bis 9, umfassend:
Schritt 1, Einstellen von Betriebsparametern für eine erste Ionenquellenvorrichtung;
Schritt 2, Ätzen von Wafer (12) -Proben;
Schritt 3, Messen der Gleichförmigkeit der geätzten Wafer (12) -Proben;
Schritt 4, Weitergehen zu einem nachfolgenden Schritt, wenn ein Messergebnis voreingestellte Anforderungen erfüllt; Umverteilen von Leistung von den ersten Entladungsspulen (5) zu den vierten Entladungsspulen (8), wenn das Messergebnis die voreingestellten Anforderungen nicht erfüllt, Regulieren der Betriebsparameter für die Ionenquellenvorrichtung und dann Zurückkehren zu Schritt 2 zur erneuten Verarbeitung; und
Schritt 5, Beendigung eines gesamten Prozesses und Fortfahren mit der Optimierung eines nachfolgenden Parametersatzes.

11. Verfahren nach Anspruch 10, wobei in Schritt 4 der Schritt des Umverteilens von Leistung von den ersten Entladungsspulen (5) zu den vierten Entladungsspulen (8) in der Ionenquellenvorrichtung folgende Schritte einschließt:
Verstellen der Hochfrequenzleistungen der vier Entladungsbereiche entsprechend den durch die Messung erhaltenen Dichtepegeln des ersten Plasmaentladungsbereichs (21), des zweiten Plasmaentladungsbereichs (22), des dritten Plasmaentladungsbereichs (23) und des vierten Plasmaentladungsbereichs (24) nach oben oder unten, um die Einstellung der Parameter abzuschließen; wobei der erste Plasmaentladungsbereich (21) in der Entladungskammer durch die ersten Entladungsspulen (5) gebildet wird, der zweite Plasmaentladungsbereich (22) in der Entladungskammer durch die zweiten Entladungsspulen (6) gebildet wird, der dritte Plasmaentladungsbereich (23) in der Entladungskammer durch die dritten Entladungsspulen (7) gebildet wird, der vierte Plasmaentladungsbereich (24) in der Entladungskammer durch die vierten Entladungsspulen (8) gebildet wird.

12. Verfahren nach Anspruch 11, wobei der Schritt des Hoch- oder Herunterverstellens der Hochfrequenzleistungen der vier Entladungsbereiche entsprechend den durch die Messung erhaltenen Dichtepegeln des ersten Plasmaentladungsbereichs (21), des zweiten Plasmaentladungsbereichs (22), des dritten Plasmaentladungsbereichs (23) und des vierten Plasmaentladungsbereichs (24) folgende Schritte einschließt:
Herunterstellen der Hochfrequenzleistungen der ersten Entladungsspulen (5) und der zweiten Entladungsspulen (6), um die Plasmadichten des ersten Plasmaentladungsbereichs (21) und des zweiten Plasmaentladungsbereichs (22) zu verringern, oder Hochstellen der Hochfrequenzleistungen der dritten Entladungsspulen (7) und der vierten Entladungsspulen (8), um die Plasmadichten des dritten Plasmaentladungsbereichs (23) und des vierten Plasmaentladungsbereichs (24) zu erhöhen, in einem Fall, in dem die Plasmadichten des ersten Plasmaentladungsbereichs (21) und des zweiten Plasmaentladungsbereichs (22) der Proben des Wafers (12) hoch sind, wenn ein Ätzergebnis der Proben des Wafers (12) darin besteht, dass eine zentrale Ätzrate hoch ist und eine Ätzrate am Rand niedrig ist;
Invertieren des in die dritten Entladungsspulen (7) und die vierten Entladungsspulen (8) eintretenden Stroms mit dem in die ersten Entladungsspulen (5) und die zweiten Entladungsspulen (6) eintretenden Strom, um eine Plasmaverteilung in dem dritten Plasmaentladungsbereich (23) und dem vierten Plasmaentladungsbereich (24) zu verringern.

13. Vakuumbehandlungssystem, das die Ionenquellenvorrichtung nach einem der Ansprüche 1 bis 9 umfasst.

## Revendications

1. Appareil de source d'ions, comprenant une cavité de décharge (9), dans lequel un axe central cylindrique de la cavité de décharge (9) est un axe central de l'appareil de source d'ions, une plaquette (12) est agencée au niveau d'une position sur l'axe central de l'appareil de source d'ions où elle est relative à une extrémité ouverte de la cavité de décharge (9) ; l'appareil de source d'ions comprenant en outre : un diviseur de puissance, de premières bobines de décharge (5), dans lequel une extrémité fermée de la cavité de décharge (9) est en forme de U, les premières bobines de décharge (5) sont emmanchées sur une paroi latérale externe cylindrique de la cavité de décharge (9), et les premières bobines de décharge (5) sont configurées pour former une première région de décharge de plasma (21) pour une décharge de plasma au niveau d'une position à l'intérieur de la cavité de décharge (9) à proximité de la paroi latérale externe cylindrique ;
de deuxièmes bobines de décharge (6), agencées au niveau d'une partie saillante en forme de U de la cavité de décharge (9), dans lequel les deuxièmes bobines de décharge (6) sont configurées pour former une deuxième région de décharge de plasma (22) pour une décharge de plasma au niveau d'une position à l'intérieur de la cavité de décharge (9) à proximité de la partie saillante en forme de U ; et
au moins deux couches de maillages de grille ionique (10, 11), posées au niveau de l'extrémité ouverte de la cavité de décharge (9) ;
dans lequel à la fois les premières bobines de décharge (5) et les deuxièmes bobines de décharge (6) sont connectées au diviseur de puissance,
dans lequel l'appareil de source d'ions comprend en outre de troisièmes bobines de décharge (7) qui sont agencées coaxialement avec les premières bobines de décharge (5) sur une paroi latérale interne d'une rainure en forme de U, et qui sont configurées pour former une troisième région de décharge de plasma (23) pour une décharge de plasma au niveau d'une position à l'intérieur de la cavité de décharge (9) à proximité de la paroi latérale interne de la rainure en forme de U ;
dans lequel les troisièmes bobines de décharge (7) sont connectées au diviseur de puissance,
dans lequel l'appareil de source d'ions comprend en outre de quatrièmes bobines de décharge (8) qui sont agencées sur une paroi inférieure interne de la rainure en forme de U, et qui sont configurées pour former une quatrième région de décharge de plasma (24) pour une décharge de plasma au niveau d'une position à l'intérieur de la cavité de décharge (9) à proximité de la paroi inférieure interne de la rainure en forme de U,
dans lequel, les quatrièmes bobines de décharge (8) sont connectées au diviseur de puissance.

2. Appareil de source d'ions selon la revendication 1, dans lequel les premières bobines de décharge (5) sont emmanchées sur un côté externe de la cavité de décharge (9), et un premier espace radial R1 est prévu entre les premières bobines de décharge (5) et une paroi périphérique de la cavité de décharge (9), où le premier espace radial R1 va de 2 mm à 30 mm ; et/ou
un deuxième espace axial L1 est prévu entre les deuxièmes bobines de décharge (6) et la partie saillante en forme de U de la cavité de décharge (9), où le deuxième espace axial L1 va de 2 mm à 30 mm ; et/ou
un troisième espace radial R2 est prévu entre les troisièmes bobines de décharge (7) et la paroi latérale interne de la rainure en forme de U de la cavité de décharge (9), où le troisième espace radial R2 va de 2 mm à 30 mm, et/ou
un quatrième espace axial L2 est prévu entre les quatrièmes bobines de décharge (8) et la paroi inférieure interne de la rainure en forme de U de la cavité de décharge (9), où le quatrième espace axial L2 va de 2 mm à 30 mm.

3. Appareil de source d'ions selon la revendication 1, dans lequel l'appareil de source d'ions comprend un dispositif de mise en correspondance de fréquence radio et un dispositif de commande maître de source d'ions (17) ; les premières bobines de décharge (5), les deuxièmes bobines de décharge (6), les troisièmes bobines de décharge (7) et les quatrièmes bobines de décharge (8) sont simultanément connectées au diviseur de puissance ; le diviseur de puissance, le dispositif de mise en correspondance de fréquence radio et le dispositif de commande maître de source d'ions (17) sont connectés séquentiellement.

4. Appareil de source d'ions selon la revendication 3, comprenant en outre un neutralisateur (16) et une alimentation électrique en courant continu, dans lequel le dispositif de commande maître de source d'ions (17) est connecté séquentiellement à l'alimentation électrique en courant continu et au neutralisateur (16).

5. Appareil de source d'ions selon la revendication 1, dans lequel l'appareil de source d'ions comprend un tuyau d'entrée d'air (13) agencé pour passer verticalement à travers la paroi inférieure interne de rainure en forme de U au niveau d'une position centrale de la paroi inférieure interne de rainure en forme de U de l'extrémité fermée.

6. Appareil de source d'ions selon la revendication 1, dans lequel une largeur de la partie saillante en forme de U de la cavité de décharge (9) est RP, un rayon de la paroi inférieure interne de la rainure en forme de U de la cavité de décharge (9) est RU, où RU/RP va de 1:3 à 3:1.

7. Appareil de source d'ions selon la revendication 1, dans lequel un nombre de couches des maillages de grille ionique (10, 11) va de 3 à 7.

8. Appareil de source d'ions selon la revendication 1, dans lequel un rayon de l'extrémité ouverte de la cavité de décharge (9) est RC, et une taille du rayon RC correspond à une taille de la plaquette (12) ;
lorsque la taille de la plaquette (12) est d'environ 20 cm, la taille de la cavité R va de 50 mm à 250 mm ; ou
lorsque la taille de la plaquette (12) est d'environ 30 cm, la taille de la cavité R va de 100 mm à 300 mm.

9. Appareil de source d'ions selon la revendication 8, dans lequel, lorsque la taille de la plaquette (12) est d'environ 30 cm, la taille du rayon RC va de 180 mm à 250 mm.

10. Procédé d'utilisation de l'appareil de source d'ions selon l'une quelconque des revendications 1 à 9, comprenant :
Étape 1, réglage des paramètres de fonctionnement d'un appareil de source d'ions initial ;
Étape 2, gravure d'échantillons de plaquette (12) ;
Étape 3, mesure d'une uniformité des échantillons de plaquette (12) gravés ;
Étape 4, passage à une étape suivante lorsqu'un résultat de mesure satisfait à des exigences prédéfinies ;
redistribution, lorsque le résultat de mesure ne satisfait pas aux exigences prédéfinies, de puissances des premières bobines de décharge (5) aux quatrièmes bobines de décharge (8), régulation des paramètres de fonctionnement de l'appareil de source d'ions, puis retour à l'étape 2 pour un retraitement ; et
Étape 5, cessation d'un processus entier et passage à l'optimisation d'un ensemble de paramètres suivant.

11. Procédé selon la revendication 10, dans lequel, à l'étape 4, l'étape de redistribution des puissances des premières bobines de décharge (5) aux quatrièmes bobines de décharge (8) dans l'appareil de source d'ions comprend les étapes consistant à :
augmenter ou réduire, en fonction de niveaux de densité de la première région de décharge de plasma (21), de la deuxième région de décharge de plasma (22), de la troisième région de décharge de plasma (23) et de la quatrième région de décharge de plasma (24) obtenus par la mesure, les puissances de fréquence radio des quatre régions de décharge pour terminer le réglage des paramètres ; dans lequel la première région de décharge de plasma (21) est formée dans la chambre de décharge par les premières bobines de décharge (5), la deuxième région de décharge de plasma (22) est formée dans la chambre de décharge par les deuxièmes bobines de décharge (6), la troisième région de décharge de plasma (23) est formée dans la chambre de décharge par les troisièmes bobines de décharge (7), la quatrième région de décharge de plasma (24) est formée dans la chambre de décharge par les quatrièmes bobines de décharge (8).

12. Procédé selon la revendication 11, dans lequel l'étape consistant à augmenter ou réduire, en fonction de niveaux de densité de la première région de décharge de plasma (21), de la deuxième région de décharge de plasma (22), de la troisième région de décharge de plasma (23) et de la quatrième région de décharge de plasma (24) obtenus par la mesure, les puissances de fréquence radio des quatre régions de décharge, comprend les étapes consistant à :
réduire les puissances de fréquence radio des premières bobines de décharge (5) et des deuxièmes bobines de décharge (6) pour diminuer les densités de plasma de la première région de décharge de plasma (21) et de la deuxième région de décharge de plasma (22), ou augmenter les puissances de fréquence radio des troisièmes bobines de décharge (7) et des quatrièmes bobines de décharge (8) pour augmenter les densités de plasma de la troisième région de décharge de plasma (23) et de la quatrième région de décharge de plasma (24), dans le cas où les densités de plasma de la première région de décharge de plasma (21) et de la deuxième région de décharge de plasma (22) des échantillons de plaquette (12) sont élevées lorsqu'un résultat de gravure des échantillons de plaquette (12) est qu'une vitesse de gravure centrale est rapide et qu'une vitesse de gravure de bord est lente ;
inverser le courant entrant dans les troisièmes bobines de décharge (7) et les quatrièmes bobines de décharge (8) avec le courant entrant dans les premières bobines de décharge (5) et les deuxièmes bobines de décharge (6) pour diminuer une distribution de plasma dans la troisième région de décharge de plasma (23) et la quatrième région de décharge de plasma (24).

13. Système de traitement sous vide, comprenant l'appareil de source d'ions selon l'une quelconque des revendications 1 à 9.
